(19) Europäisches Patentamt / European Patent Office / Office européen des brevets

(11) **EP 3 581 006 B1**

(12) **EUROPÄISCHE PATENTSCHRIFT**

(45) Veröffentlichungstag und Bekanntmachung des Hinweises auf die Patenterteilung:
**29.03.2023 Patentblatt 2023/13**

(21) Anmeldenummer: **17714768.3**

(22) Anmeldetag: **31.03.2017**

(51) Internationale Patentklassifikation (IPC):
**H05K 13/08** (2006.01)

(52) Gemeinsame Patentklassifikation (CPC):
**H05K 13/085**

(86) Internationale Anmeldenummer:
**PCT/EP2017/057713**

(87) Internationale Veröffentlichungsnummer:
**WO 2018/177538 (04.10.2018 Gazette 2018/40)**

(54) **VERFAHREN UND STEUERUNGSEINRICHTUNG ZUR DURCHSATZOPTIMIERTEN PRODUKTION VON LEITERPLATTEN AUF MEHREREN BESTÜCKUNGSLINIEN**

METHOD AND CONTROL DEVICE FOR THE THROUGHPUT-OPTIMISED PRODUCTION OF PRINTED CIRCUIT BOARDS ON MULTIPLE ASSEMBLY LINES

PROCÉDÉ ET DISPOSITIF DE COMMANDE POUR LA PRODUCTION À RENDEMENT OPTIMISÉ DE CARTES DE CIRCUITS IMPRIMÉS SUR PLUSIEURS LIGNE DE MONTAGE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(43) Veröffentlichungstag der Anmeldung:
**18.12.2019 Patentblatt 2019/51**

(73) Patentinhaber: **Siemens Aktiengesellschaft**
**80333 München (DE)**

(72) Erfinder:
• **PFAFFINGER, Alexander**
**81739 München (DE)**
• **ROYER, Christian**
**85521 Ottobrunn (DE)**

(74) Vertreter: **Siemens Patent Attorneys**
**Postfach 22 16 34**
**80506 München (DE)**

(56) Entgegenhaltungen:
DE-A1-102012 211 810      DE-A1-102014 222 936
DE-A1-102014 222 940

**Beschreibung**

Die Erfindung betrifft ein Verfahren zur durchsatzoptimierten Produktion von Leiterplatten auf mehreren Bestückungslinien. Weiterhin betrifft die Erfindung eine Steuerungseinrichtung für ein Bestückungssystem bzw. eine Fertigungs- oder Montagelinie zur Bestückung von Leiterplatten (Baugruppen) mit Bauelementen bzw. Bauteilen. Außerdem betrifft die Erfindung ein Computerprogrammprodukt.

Insbesondere im Bereich der Elektronikproduktion werden zu fertigende Leiterplatten bzw. Baugruppen auf SMT-Bestückungslinien durch Oberflächenmontage (surface mounted technology, SMT) hergestellt. Ein Hersteller von SMT-Bestückungsautomaten (pick and place) und -systeme mit dem Produktnamen SIPLACE ist beispielsweise die Firma ASM (http://www.siplace.com/en/Home) .

Mehrere Bestückungsautomaten, die üblicherweise durch ein Transportsystem verbunden sind, und die z.B. zum Fertigen bzw. zum Produzieren von (Elektronik-)bauteilen bzw. Leiterplatten zusammenwirken, stellen eine Bestückungslinie dar.

Bei Bestückungsautomaten z.B. zum Bestücken von Baugruppen mit Bauelementen werden seitlich an einer Transportstrecke für die Baugruppe Wechseltische für Zuführvorrichtungen für Bauelemente angeordnet.

Die Wechseltische umfassen jeweils eine Vielzahl Zuführungseinrichtungen. Jede Zuführungseinrichtung hält einen Vorrat von Bauelementen eines vorbestimmten Bauelementtyps bereit. Für die Bauelemente hat die Zuführungseinrichtung ein Fassungsvermögen (Platzkapazität), das üblicherweise in Spuren bzw. Spurkapazitäten ausgedrückt wird.

Jede Zuführungseinrichtung kann zur Bereithaltung unterschiedlicher Bauelemente konfiguriert werden und üblicherweise können unterschiedliche Zuführungseinrichtungen an einem Wechseltisch angebracht werden. Wird ein Bauelement eines Bauelementtyps an einem bestimmten Bestückungsautomaten benötigt, der nicht in einem der Wechseltische vorhanden ist, so wird üblicherweise nicht einer der angebrachten Wechseltische mit den benötigten Bauelementen versehen, sondern komplett gegen einen anderen, entsprechend bestückten Wechseltisch ausgetauscht. Das Aufrüsten eines einzuwechselnden Wechseltischs mit Bauelementen wird Vorrüstung genannt und kann eine Bearbeitungszeit im Stundenbereich erfordern.

Weiterhin ist es z.B. aus der Elektronikfertigung bekannt, die auf einer Bestückungslinie zu fertigenden Lose in Rüstfamilien zusammenzufassen. Alle Lose einer Rüstfamilie werden jeweils mit derselben Linienrüstung gefertigt. Eine Rüstfamilie, auch Cluster genannt, umfasst eine Menge von Losen, die innerhalb einer Rüstung gefertigt werden kann. Alle Baugruppen einer Rüstfamilie können also nacheinander ohne Umrüsten auf der Bestückungslinie gefertigt werden.

Aus DE 10 2012 211810 A1 ist ein Verfahren zur Bildung von Rüstfamilien auf Bestückungslinien bekannt.

Eine Rüstung kann auf einem oder mehreren Rüsttischen gehalten werden, die leicht am Bestückungsautomaten ausgewechselt werden können. Ein Aufrüsten eines Rüsttischs mit Bauelementen von vorbestimmten Bauelementtypen ist jedoch - wie oben bereits beschrieben - aufwändig. Die Rüstungen werden daher oft in Festrüstungen und Variantenrüstungen unterschieden, wobei ein Festrüstungstisch dazu vorgesehen ist, seine Zusammensetzung von Bauelementtypen über einen vorbestimmten Planungszeitraum zu behalten, während ein Variantenrüsttisch voraussichtlich innerhalb des Planungszeitraums umgerüstet wird.

Der typische Rüstbetrieb an einer SMT-Bestückungslinie innerhalb einer kurzfristigen Planungsperiode, beginnend bei der Planung bis hin zur Ausführung, sieht folgendermaßen aus:
Die Dauer eines kurzfristigen Planungszeitraums beträgt normalerweise zwischen ein und fünf Tagen. Zu Beginn einer Planungsperiode erhält der Produktionsplaner gewöhnlich aus einem EDV-System neue Fertigungsaufträge. Er hat aber auch noch einen Restbestand an alten, noch nicht eingeplanten Fertigungsaufträgen aus der Vorperiode. Die Aufträge werden, wenn möglich, mit bestehenden Festrüstungen gefertigt. Für den Rest werden variable Rüstungen (auch Variantenrüstungen genannt) erstellt.

Während mit einer aktiven Rüstung an der Bestückungslinie bestückt wird, wird im Vorrüstbereich bereits die nächste Rüstung auf einem für variable Rüstungen vorgehaltenen Wechseltischsatz vorbereitet. Eine Menge von pro Rüstung notwendigen Wechseltischen wird hierbei als Wechseltischsatz bezeichnet. Dauert die Vorbereitung zu lange, so kommt es zu einer Stillstandzeit der Bestückungslinie.

Auch Umrüstvorgänge für den Rüstwechsel von einer Rüstfamilie auf eine andere Rüstfamilie ziehen Stillstandzeiten von typischerweise 30 min nach sich.

Stillstandzeiten mindern den Durchsatz auf den Bestückungslinien und sollten somit unbedingt vermieden werden.

Aus DE 10 2014 222940 A1 ist ein Verfahren zur Bestückung von Leiterplatten mit Bauelementen auf einer Bestückungsanlage bekannt, wobei eine Festrüstung und mehrere Variantenrüstungen bestimmt wird.

Aus DE 10 2014 222936 A1 ist ein Verfahren zum Bestücken von Leiterplatten mittels einer Bestückungslinie bekannt, wobei mehrere Rüstungen mit jeweils zugeordneten Rüstfamilien gebildet werden.

In der Praxis werden die variablen Rüstungen gewöhnlich mit einem Cluster-Tool wie z.B. SiCluster erstellt.

Die in einer zeitlichen Sequenz geordnete Rüstreihenfolge im Vorrüstbereich wird derzeit vom Produktionsplaner manuell erstellt.

Aus PCT/EP2017/051997 ist bereits ein Verfahren bzw. eine Steuereinrichtung vorgeschlagen worden, die den Durchsatz auf einer Bestückungslinie optimiert.

Es ist Aufgabe der vorliegenden Erfindung, den Durchsatz nun insgesamt auf mehreren Bestückungslinien zu optimieren.

Diese Aufgabe wird durch die unabhängigen Ansprüche gelöst. Vorteilhafte Weiterbildungen sind Gegenstand der abhängigen Ansprüche.

Die Erfindung beansprucht ein Verfahren zur durchsatzoptimierten Produktion von Leiterplatten (120) auf mindestens zwei Bestückungslinien (110), wobei die Leiterplatten in Gruppen aufgeteilt sind, die Cluster genannt werden, wobei ein Cluster (175) jeweils mittels einer Rüstung gefertigt wird, wobei die Rüstung durch an den Bestückungslinien anbringbaren Wechseltische (140) realisiert wird, die jeweils mindestens eine Zuführungseinrichtung (150) zum Bereithalten von Vorräten von Bauelementen (155) aufweisen, wobei eine Menge von pro Rüstung notwendigen Wechseltischen als Wechseltischsatz bezeichnet wird und ein leerer Wechseltischsatz Wechseltische aufweist, deren Zuführungseinrichtungen leer sind,

- wobei eine Rüstung temporär auf leeren Wechseltischsätzen aufgerüstet und nach der Produktion von Leiterplatten durch deren Bestückung abgerüstet wird, und

- wobei einer der Wechseltischsätze erst dann in der Produktion einsetzbar ist, wenn er vollständig in einem Vorrüstbereich aufgerüstet worden ist, und der Wechseltischsatz erst dann wieder aufrüstbar ist, wenn die mit dem Wechseltischsatz durchgeführte Produktion beendet und der Wechseltischsatz im Vorrüstbereich wieder abgerüstet worden ist,

wobei das Verfahren folgende Schritte umfasst:

a) Erfassen einer Menge von Bestückungslinien,
b) Erfassen einer Menge von Clustern,
c) Erfassen einer Anzahl an leeren Wechseltischsätzen pro Bestückungslinie,
d) Erfassen der jeweiligen Zeitdauern für das Erstellen der Rüstung für die einzelnen Cluster der erfassten Menge von Clustern pro Bestückungslinie,
e) Erfassen der jeweiligen Produktionszeitdauern für die Fertigung der einzelnen Cluster der erfassten Menge von Clustern auf einer der Bestückungslinien,
f) Auswählen einer Zuordnung von Wechseltischsätzen zu Positionen in einer zeitlichen Reihenfolge, in welcher die Wechseltischsätze im Vorrüstbereich gerüstet werden und in der gleichen zeitlichen Reihenfolge in der Produktion verwendet werden, wobei die Anzahl der Positionen in der zeitlichen Reihenfolge der Anzahl der erfassten Cluster entspricht und jeder Position ein Cluster zugeordnet wird,
g) Optimierung einer Zuordnung der Cluster auf die Bestückungslinien und der Reihenfolge der zugeordneten Cluster pro Bestückungslinie, so dass die Durchlaufzeit insgesamt bezogen auf alle Bestückungslinien minimiert wird, und
h) Durchführung der Produktion der Leiterplatten mit Hilfe der in g) berechneten, optimierten Zuordnung und Reihenfolge der Cluster.

Ein leerer Wechseltischsatz weist in der Regel ungerüstete bzw. noch nicht gerüstete Wechseltische auf. Die Zuführungseinrichtungen sind dabei leer und nicht mit Bauteilen zur Bestückung gerüstet.

Die Wechseltischsätze können hierbei jeweils an Positionen in einer zeitlichen Reihenfolge, in welcher die Wechseltischsätze im Vorrüstbereich gerüstet werden und in der gleichen zeitlichen Reihenfolge in der Produktion verwendet bzw. eingesetzt werden, zugeordnet werden.

Die Erfindung bringt den Vorteil mit sich, dass der Durchsatz in der Leiterplattenproduktion gesteigert werden kann. Es sind optimale Berechnungen für die oben genannte Zuordnung auf die Bestückungslinien und für die Reihenfolge möglich, wodurch unter anderem auch eine automatisierte Unterstützung in der Produktionsplanung erreicht wird.

Eine Weiterbildung der Erfindung sieht vor, dass jeweils eine maximale Produktionszeitdauer pro Bestückungslinie festlegbar ist bzw. festgelegt werden kann. Diese maximale Produktionszeitdauer kann in die obige Optimierung eingehen.

Eine Weiterbildung der Erfindung sieht vor, dass aus der Menge der Cluster eine Untermenge an Clustern vorgebbar bzw. bestimmbar ist, die auf einer bestimmbaren oder bestimmten Bestückungslinie der Bestückungslinien nicht gefertigt werden dürfen bzw. können.

Eine Weiterbildung der Erfindung sieht weitere folgende Verfahrensschritte vor:

- Erfassen eines oder mehrerer frühestmöglicher Zeitpunkte für den Beginn des Einsatzes eines Wechseltischsatzes pro Bestückungslinie,
- Erfassen eines frühestmöglichen Zeitpunkts für den Beginn der Produktion pro Bestückungslinie,
- Erfassen eines frühestmöglichen Zeitpunkts für den Beginn des Rüstens im Vorrüstbereich, und

  - Optimierung der genannten Zuordnung und Reihenfolge der Cluster unter Berücksichtigung der erfassten frühesten Zeitpunkte.

Damit kann die Wartezeit verringert werden, die dabei entsteht, dass für den Einsatz bzw. die Verwendung eines Wechseltischsatzes in der Produktion darauf gewartet werden muss, bis der Wechseltischsatz im Vorrüstbereich fertig gerüstet worden.

Eine Weiterbildung der Erfindung sieht eine Durchführung der Optimierung der Zuordnung und Reihenfolge der Cluster mit Hilfe von Gemischt Ganzzahliger Linearer Optimierung vor.

Eine Weiterbildung der Erfindung sieht vor, dass in die gemischt ganzzahlige lineare Optimierung Cluster unterteilt in reale Cluster und virtuelle Cluster, auch Füll- bzw. Dummy-Cluster genannt, eingehen, wobei nach Optimierung der Zuordnung und der Reihenfolge der Cluster (s.o. Schritt g)) die virtuellen Cluster herausgenommen bzw. entfernt werden und die übrigen Cluster in der jeweiligen Reihenfolge aufrücken. Die virtuellen Cluster werden für die lineare Optimierung verwendet, werden so gesehen als eine Art Platzhalter benutzt, entsprechen jedoch keinen realen Clustern.

Es können auf mindestens zwei Bestückungslinien eine Anzahl an realen Clustern mit deren realen Rüstungen sowie eine gleiche Anzahl an virtuellen Clustern mit virtuellen Rüstungen fertiggestellt werden. Für die Fertigstellung der realen Cluster mit deren realen Rüstungen stehen normalerweise zwei Wechseltischsätze zur Verfügung. Diese Cluster können auf die jeweiligen Bestückungslinien zugeordnet und eine Reihenfolge (1, 2, ..., 5) für die Erstellung der jeweiligen Rüstungen für die Produktion des entsprechenden Clusters aus- bzw. festgelegt werden. Die Optimierung der Zuordnung der Cluster und der Reihenfolge kann iterativ mit dem oben genannten Optimierungsverfahren bzw. -methode, insbesondere mit Hilfe von Gemischt Ganzzahliger Linearer Optimierung, erfolgen.

Eine Weiterbildung der Erfindung sieht vor, dass unterschiedliche Typen von Rüstungen verwendet werden, wobei ein erster Typ einer Festrüstung entspricht, die nach einem einmaligen Rüsten unverändert bleibt und vor der Produktion nicht ab- bzw. aufgerüstet wird. Pro Festrüstung ist ein Wechseltischsatz vorgesehen. Ein zweiter Typ entspricht einer Variantenrüstung, die - wie eingangs erläutert - veränderbar ist. Für die Variantenrüstungen ist mindestens ein Wechseltischsatz vorgesehen. Jedes Cluster wird mit einer Rüstung eines vorgebbaren Typs der genannten Typen gefertigt bzw. produziert.

Eine Weiterbildung der Erfindung sieht vor, dass zusätzlich Umrüstzeiten erfasst und für die Optimierung berücksichtigt werden, die durch das Wechseln der Wechseltischsätze beim Übergang von einer Rüstung auf eine andere Rüstung auftreten.

Um den Durchsatz zu verbessern, können in der Produktion zwischen die Cluster mit Variantenrüstungen geschickt eine oder mehrere Cluster mit Festrüstungen dazwischengeschoben werden.

Eine Weiterbildung der Erfindung sieht vor, dass ein Cluster mit einer Festrüstung aufgeteilt werden kann und mehrfach in die Reihenfolge der Cluster eingebracht werden kann.

Zudem kann ein Cluster mit einer Festrüstung zu Beginn und/oder am Ende in die Reihenfolge der Cluster eingebracht werden.

Ein weiterer Aspekt der Erfindung sieht eine Steuerungseinrichtung vor, insbesondere zur Durchführung des Verfahren zur durchsatzoptimierten Produktion von Leiterplatten auf mindestens zwei Bestückungslinien nach einem der vorhergehenden Ansprüche, wobei die Leiterplatten in Gruppen aufteilbar sind, die Cluster genannt werden, wobei ein Cluster jeweils mittels einer Rüstung gefertigt wird, wobei die Rüstung durch an den Bestückungslinien anbringbaren Wechseltische realisierbar ist, die jeweils mindestens eine Zuführungseinrichtung zum Bereithalten von Vorräten von Bauelementen aufweisen, wobei eine Menge von pro Rüstung notwendigen Wechseltischen als Wechseltischsatz bezeichnet wird und ein leerer Wechseltischsatz Wechseltische aufweist, deren Zuführungseinrichtungen leer sind,

- wobei eine Rüstung temporär auf leeren Wechseltischsätzen aufrüstbar und nach der Produktion von Leiterplatten durch deren Bestückung abrüstbar ist, und

  - wobei einer der Wechseltischsätze erst dann in der Produktion einsetzbar ist, wenn er vollständig in einem Vorrüstbereich aufgerüstet worden ist, und der Wechseltischsatz erst dann wieder aufrüstbar ist, wenn die mit dem Wechseltischsatz durchgeführte Produktion beendet und der Wechseltischsatz im Vorrüstbereich wieder abgerüstet worden ist,

wobei die Steuereinheit folgende Erfassungseinrichtungen

a) zum Erfassen einer Menge von Bestückungslinien,

b) zum Erfassen einer Menge von Clustern,

c) zum Erfassen einer Anzahl an leeren Wechseltischsätzen,

d) zum Erfassen der jeweiligen Zeitdauern für das Erstellen der Rüstung für die einzelnen Cluster der erfassten Menge von Clustern pro Bestückungslinie,

e) zum Erfassen der jeweiligen Produktionszeitdauern für die Fertigung der einzelnen Cluster der erfassten Menge von Clustern auf einer der Bestückungslinien,

f) zum Auswählen einer Zuordnung von Wechseltischsätzen zu Positionen in einer zeitlichen Reihenfolge, in welcher die Wechseltischsätze im Vorrüstbereich gerüstet werden und in der gleichen zeitlichen Reihenfolge in der Produktion verwendet werden, wobei die Anzahl der Positionen in der zeitlichen Reihenfolge der Anzahl der erfassten Cluster entspricht und jeder Position ein Cluster zugeordnet wird, und

g) Solver zur Optimierung einer Zuordnung der Cluster auf die Bestückungslinien und der Reihenfolge der zugeordneten Cluster pro Bestückungslinie, so dass die Durchlaufzeit insgesamt bezogen auf alle Bestückungslinien minimiert ist, sowie

h) eine Steuerung zur Durchführung der Produktion der Leiterplatten mit Hilfe der in g) berechneten, optimierten Zuordnung und Reihenfolge der Cluster, aufweist.

Die Steuerungseinrichtung kann Mittel und/oder Einheiten bzw. Einrichtungen und/oder Module zur Durchführung des oben genannten Verfahrens vorsehen, die jeweils hardwaremäßig und/oder firmwaremäßig und/oder softwaremäßig bzw. als Computerprogramm bzw. Computerprogrammprodukt ausgeprägt sein können. Diese Einrichtungen bzw. Mittel können einzeln für sich oder zusammengefasst in ein oder mehreren Einheiten implementiert werden.

Die Steuerungseinrichtung kann wie das oben beschriebene Verfahren entsprechend weitergebildet werden.

Ein weiterer Aspekt der Erfindung kann ein Bestückungssystem sein, das eine solche erfindungsgemäße Steuerungseinrichtung aufweist.

Dieses Bestückungssystem kann Teil einer Anlage sein.

Die Anlage kann unter anderem durch einen der folgenden Anlagentypen charakterisiert sein. Beispiele hierfür sind eine Automatisierungsanlage oder eine Fertigungs- bzw. Produktionsanlage.

Ein weiterer Aspekt der Erfindung ist ein Computerprogrammprodukt bzw. ein Computerprogramm mit Mitteln zur Durchführung des oben genannten Verfahrens, wenn das Computerprogramm (-produkt) in einer oben genannten Steuerungseinrichtung oder in Mitteln der Vorrichtung zur Ausführung gebracht wird. Das Computerprogramm bzw. -produkt kann auf einem computerlesbaren Medium gespeichert sein. Das Computerprogramm bzw. - produkt kann in einer üblichen Programmiersprache (z.B. C++, Java) erstellt sein. Die Verarbeitungseinrichtung kann einen marktüblichen Computer oder Server mit entsprechenden Eingabe-, Ausgabe- und Speichermitteln umfassen. Diese Verarbeitungseinrichtung kann in der Steuerungseinrichtung oder in deren Mitteln integriert sein.

Weitere Vorteile, Einzelheiten und Weiterbildungen der Erfindung ergeben sich aus der nachfolgenden Beschreibung von Ausführungsbeispielen in Verbindung mit den Zeichnungen.

Es zeigen:

Fig. 1 ein Bestückungssystem beispielhaft mit zwei Bestückungslinien und

Fig. 2 eine Graphik, die die Zuordnung auf die Bestückungslinien und die Reihenfolge der Rüstvorgänge im Vorrüstbereich und die Reihenfolge der Verwendung der Rüstungen in der Produktion zeigt.

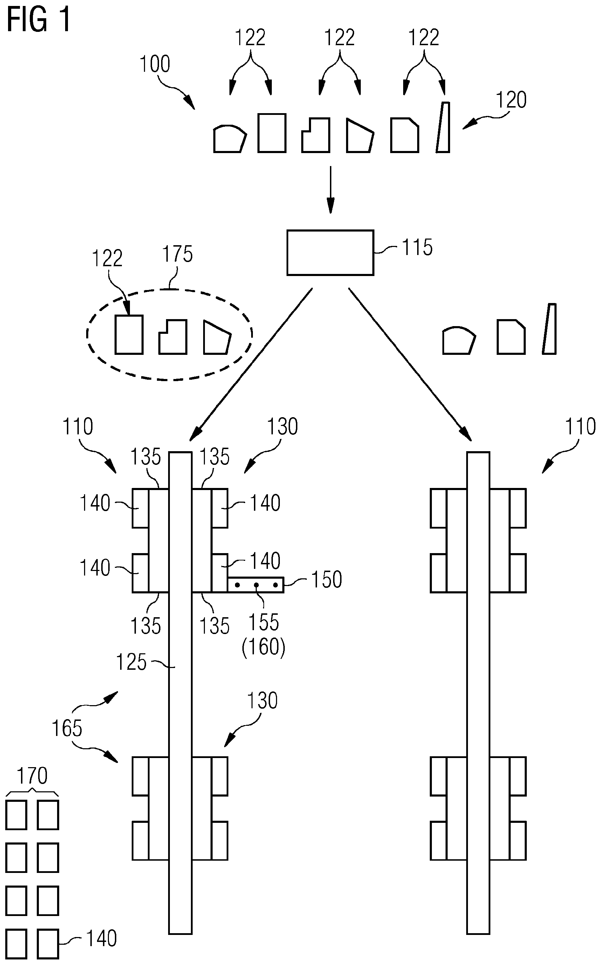

Figur 1 zeigt ein beispielhaftes Bestückungssystem 100. Das Bestückungssystem 100 umfasst mehrere Bestückungslinien 110 und eine Verarbeitungs- oder Steuerungseinrichtung 115. Jede Bestückungslinie 110 umfasst ein optionales Transportsystem 125 sowie einen oder mehrere Bestückungsautomaten 130. Jeder Bestückungsautomat 130 umfasst einen oder mehrere Bestückungsköpfe 135, die jeweils dazu eingerichtet sind, von einem Rüsttisch 140 Bauelemente 155 aufzunehmen und an einen vorbestimmten Platz auf der Leiterplatte 120 zu positionieren, die sich auf dem Transportsystem 125 befindet. Während des Bestückungsvorgangs steht die Leiterplatte 120 bezüglich des Bestückungsautomaten 130 üblicherweise still.

Die Rüsttische 140 umfassen jeweils eine Vielzahl Zuführungseinrichtungen 150, von denen in Figur 1 exemplarisch nur eine dargestellt ist. Jede Zuführungseinrichtung 150 hält einen Vorrat von Bauelementen 155 eines vorbestimmten Bauelementtyps 160 bereit. Für die Bauelemente 155 hat die Zuführungseinrichtung 150 üblicherweise ein Fassungsvermögen, das in Spuren ausgedrückt werden kann. Eine Spur ist für gewöhnlich 8 mm breit und die Zahl der Spuren eines Rüsttischs 140 ist beschränkt, beispielsweise auf 40. Bauelemente 155 des gleichen Bauelementtyps 160 sind üblicherweise bereitgestellt in einem Gurt, auf einem Tablett oder in einer Röhre. Jeder Bauelementtyp 160 erfordert an der Zuführungseinrichtung 150 und am Rüsttisch 140 eine vorbestimmte Anzahl Spuren, die üblicherweise aneinander angrenzen.

Gewöhnlich kann eine Zuführungseinrichtung 150 zur Bereithaltung von Bauelementen 155 unterschiedlicher Bauelementtypen 160 konfiguriert werden und üblicherweise können unterschiedliche Zuführungseinrichtungen 150 an einem Rüsttisch 140 angebracht werden. Vorliegend wird vereinfachend davon ausgegangen, dass ein Vorrat von Bauelementen 155 eines Bauelementtyps 160 an einer Zuführungseinrichtung 150 praktisch unendlich groß ist, ein Nachrüsten also nicht erforderlich ist.

Wird am Bestückungsautomaten 130 ein Bauelement 155 eines Bauelementtyps 160 benötigt, der nicht an einem der Rüsttische 140 vorhanden ist, so wird üblicherweise nicht die Zuordnung von Bauelementen 155 an einem der angebrachten Rüsttische 140 verändert, sondern der Rüsttisch 140 wird komplett gegen einen anderen, passend bestückten Rüsttisch 140 ausgetauscht. Das Bestücken eines nicht an der Bestückungslinie 110 angebrachten Rüsttischs 140 mit Bauelementen 155 wird Vorrüstung genannt und kann eine Bearbeitungszeit im Bereich von einer oder mehreren Stunden, beispielsweise ca. 6-8 Stunden, erfordern.

Da ein Wechsel von Rüsttischen 140 an der Bestückungslinie 110, ein so genannter Rüstwechsel, üblicherweise mit einem Produktionsstillstand verbunden ist, wird angestrebt, Wechsel der Rüsttische 140 möglichst selten durchzuführen. Da ferner die Rüsttische 140 kostspielig sind und das Umrüsten eines Rüsttischs 140 aufwändig und langwierig sein kann, wird weiter versucht, möglichst wenige Rüstungen zu bilden, um eine vorbestimmte Produktionsmenge von Leiterplatten 120 vorbestimmter Leiterplattentypen 122 zu fertigen. Die Produktionsmenge umfasst hier mehrere Leiterplattentypen 122, von denen jeweils eine vorbestimmte Stückzahl Leiterplatten 120 mit Bauelementen 155 vorbestimmter Bauelementtypen 160 bestückt werden soll. Beispielsweise können 300 Leiterplatten 120 eines ersten Leiterplattentyps 122 und 200 Leiterplatten 120 eines zweiten Leiterplattentyps 122 bestückt werden.

Eine Rüstung 165, 170 umfasst eine Menge von Bauelementtypen 160 und wird realisiert durch einen oder mehrere Rüsttische 140, die bei mehreren Rüsttischen einen Wechseltischsatz bilden und jeweils mit Vorräten von Bauelementen 155 der Bauelementtypen 160 der Rüstung 165, 170 ausgestattet und an der Bestückungslinie 110 angebracht sind.

Der Rüstung 165, 170 ist eine Rüstfamilie 175 zugeordnet, die Leiterplattentypen 122 umfasst, von denen Leiterplatten 120 mittels Bauelementen 155 der Bauelementtypen 160 der Rüstung 165, 170 bestückt werden können. Eine Rüstfamilie 175 ist genau einer Rüstung 165, 170 zugeordnet und umgekehrt.

Um die Auslastung einer Bestückungslinie 110 zu erhöhen oder einen Bedarf an Rüsttischen 140 zu verringern ist es daher entscheidend, wie auf der Basis der zu bestückenden Leiterplattentypen 122 Rüstfamilien 175 gebildet werden. Bei der Bildung von Rüstungen 165, 170 bzw. Rüstfamilien 175 können Nebenbedingungen zu beachten sein, beispielsweise die Einhaltung einer begrenzten Fassungskapazität eines Rüsttisches 140 für Bauelementtypen 160 oder eine Gruppierung vorbestimmter Leiterplattentypen 160 in der gleichen Rüstfamilie 175, etwa aus Gründen der Verwendung bleihaltigen oder bleifreien Lötzinns.

Die Rüstungen können in Festrüstungen 165 und Variantenrüstungen 170 unterschieden werden, wobei eine Festrüstung 165 dazu vorgesehen ist, auf einer Anzahl Wechseltische 140 über einen vorbestimmten Planungszeitraum unverändert gerüstet zu bleiben, während ein Wechseltisch 140 einer Variantenrüstung 170 voraussichtlich innerhalb des Planungszeitraums mit Bauelementen 155 anderer Bauelementtypen 160 umgerüstet wird. Der Planungszeitraum kann beispielsweise 6 bis 12 Monate betragen. Eine Variantenrüstung 165 besteht in einer vorbestimmten Konstellation üblicherweise wesentlich kürzer als der Planungszeitraum, beispielsweise über mehrere Stunden oder Tage, üblicherweise jedoch nicht über mehr als eine Woche.

Die Rüstungen 165, 170 können nach Bedarf an der Bestückungslinie 110 ausgetauscht werden. Um eine Festrüstung 165 oder eine Variantenrüstung 170 zu realisieren wird üblicherweise ein Rüsttisch 140, während er nicht an der Bestückungslinie 110 angebracht ist, mit Vorräten von Bauelementen 155 vorbestimmter Bauelementtypen 160 aufgerüstet. Bereits aufgerüstete Bauelemente 155 nicht benötigter Bauelementtypen 160 können zuvor abgerüstet werden. Diese Umrüstung kann einen erheblichen Anteil manueller Arbeit umfassen und zeitaufwändig sein.

Um den mit einer Variantenrüstung 170 verbundenen Aufwand zu minimieren, wird versucht, in den Festrüstungen 165 möglichst viele Leiterplattentypen 122 aufzunehmen. Ein angestrebter Fall ohne Variantenrüstungen 170 ist in der Praxis jedoch kaum erzielbar.

Die Steuerungseinrichtung 115 ordnet im Rahmen der Steuerung des Bestückungssystems 100 Leiterplattentypen 122, deren zugeordnete Leiterplatten 120 auf der Bestückungslinie 110 bestückt werden sollen, jeweils einer Rüstfamilie 175 zu, wobei Festrüstungs-Rüstfamilien 175, die jeweils einer Festrüstung 165 zugeordnet ist, und Variantenrüstungs-Rüstfamilien 175, die jeweils einer Variantenrüstung 170 zugeordnet sind, gebildet werden können.

Ein Spezialfall von Optimierungsmethoden ist die lineare Optimierung. Sie befasst sich mit der Optimierung linearer Zielfunktionen über einer Menge, die durch lineare Gleichungen und Ungleichungen eingeschränkt ist. Sie ist Grundlage der Lösungsverfahren der (gemischt-) ganzzahligen linearen Optimierung. Ein sogenannter Solver (Löser) ist eine Sammelbezeichnung für spezielle mathematische Computerprogramme, die mathematische Probleme numerisch lösen können. Im Zusammenhang mit MILP (mixed integer linear programming bzw. gemischt ganzzahlige Lineare Programmierung) können für IP-Programme (ganzzahlige Optimierungsmodelle) Standardsolver wie z.B. CPLEX, Scip, Gurobi, Xpress verwendet werden.

Im Folgenden wird ein Beispiel beschrieben, in dem mittels eines MILP-Modell (Mixed Integer Linear Programming) optimale Zuordnung auf die Bestückungslinien 110 und die zeitliche Rüstreihenfolgen von vorgegebenen zu fertigenden Rüstfamilien berechnet werden. Zudem kann eine optimale zeitliche Reihenfolge für den Einsatz der gerüsteten Wechseltischsätze (Variantenrüstung) und gegebenenfalls der Festrüstungswechseltischsätze an der jeweiligen Bestückungslinie berechnet werden.

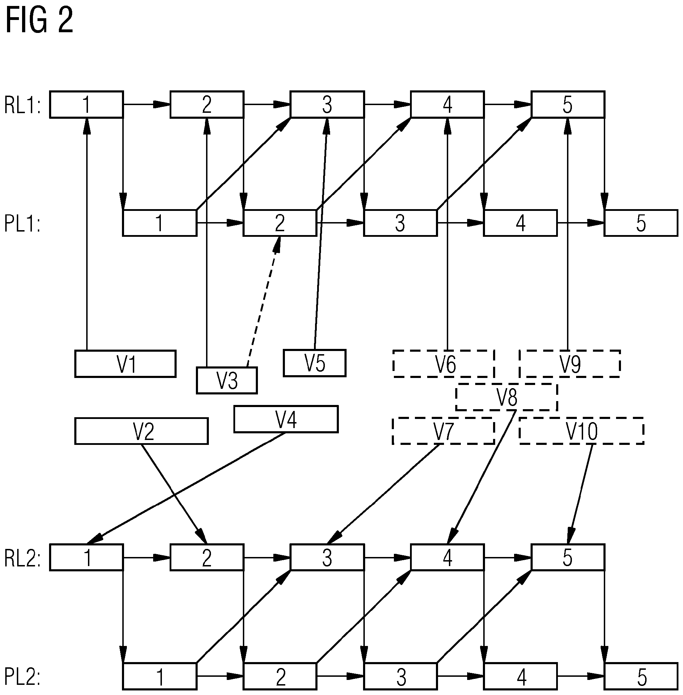

In der Figur 2 ist schematisch folgendes dargestellt:

In den ersten zwei Reihen hinsichtlich einer ersten Bestückungslinie 110 werden Positionen 1,2, ..., 5 etc. in einer bestimmten zeitlichen Reihenfolge gezeigt. Im Vorrüstbereich gibt es eine Rüstreihenfolge RL1 mit Rüstpositionen. Die variablen bzw. Varianten-Rüstungen V1, V3 und V5 werden im Beispiel dabei den Positionen 1, 2 und 3 innerhalb der Reihenfolge RL1 zugeordnet. Gibt es wie im Beispiel 5 Cluster mit variablen Rüstungen, so gibt es auch 5 Positionen (1, 2, 3, 4 und 5) innerhalb der Rüstreihenfolge, auf die die variablen Rüstungen (eineindeutig) zugeordnet bzw. zugewiesen werden. Für die Erstellung dieser Cluster mit den variablen Rüstungen steht eine gewisse Anzahl an Wechseltischsätzen zur Verfügung. Gewöhnlich gibt es zwei solche Wechseltischsätze pro Bestückungslinie. Einer der beiden Wechseltischsätze steht gerüstet an der Bestückungslinie zur Verfügung. Der andere der beiden Wechseltischsätze befindet sich im Vorrüstbereich. Vorab werden den Positionen abwechselnd die Wechseltischsätze zugeordnet, wobei bei der Zuordnung mit dem Wechseltischsatz begonnen wird, der zum frühesten Zeitpunkt zur Verfügung steht. Die Wechseltischsätze werden dann in der gleichen zeitlichen Reihenfolge 1, 2, ..., 5 etc. in der Produktion eingesetzt, in welcher sie fertig gerüstet worden sind. Dies wird durch die Pfeile zwischen den beiden Reihen angedeutet, welche Wartebeziehungen zwischen den Positionen 1 bis 5 repräsentieren. Mit anderen Worten ausgedrückt ein Wechseltischsatz muss z.B. an Position 1 erst fertig gerüstet sein, bevor er an Position 1 in der Produktion verwendet werden kann.

In der dritten Reihe sind Cluster mit Variantenrüstungen V1 bis V5 dargestellt. Die Pfeile zwischen den beiden ersten Reihen und der dritten Reihe deuten Zuordnungen von Variantenrüstungen zu den Positionen 1 bis 5 an. Es kann sinnvoll sein, dass z.B. die Variantenrüstung V3 an Position 1 und die Variantenrüstung V1 an Position 2 zu positionieren, wenn die Rüstzeit(dauer) für V3 kürzer ist als für V1. Somit würden unnötige Wartezeiten bzw. Stillstandszeiten in der Produktion vermieden werden.

Für jede Bestückungslinie entspricht die Anzahl der Positionen genau der Anzahl der insgesamt zu fertigenden realen Rüstfamilien. Zu den real zu fertigenden Rüstfamilien gibt es noch n virtuelle Rüstfamilien (n = Anzahl Positionen insgesamt abzüglich der Anzahl realen Rüstfamilien) mit Rüst- und Fertigungszeitdauern mit Betrag 0. Die Variantenrüstungen für die realen Rüstfamilien bzw. Cluster und die virtuellen Rüstungen werden den Positionen 1, 2,..., 5 etc. der Produktionsreihenfolgen PL1 bzw. PL2 der Bestückungslinien zugeordnet.

In den letzten beiden Reihen hinsichtlich einer zweiten Bestückungslinie werden ebenfalls Positionen 1,2, ..., 5 etc. in einer bestimmten zeitlichen Reihenfolge gezeigt. Im Vorrüstbereich gibt es eine Rüstreihenfolge RL2 mit Rüstpositionen. Die variablen bzw. Varianten-Rüstungen V4 und V2 werden im Beispiel dabei den Positionen 1 und 2 innerhalb der Rüstreihenfolge RL2 zugeordnet. Gibt es wie im Beispiel noch zusätzlich 5 virtuelle Rüstungen V6, V7, V8, V9, V10 und je Bestückungslinie 5 Positionen (1,2,3, und 5) innerhalb der Rüstreihenfolge, auf die alle Rüstungen V1 bis V10 eineindeutig zugeordnet bzw. zugewiesen werden, werden im Beispiel die virtuellen Rüstungen V6 und V9 auf die Positionen 4 und 5 der Rüstreihenfolge RL1 gesetzt und die virtuellen Rüstungen V7, V8 und V10 auf die Positionen 3, 4 und 5 der Rüstreihenfolge RL2 gesetzt. Diese gesetzte Reihenfolge kann als eine Start-Auswahl angesehen werden, welche im nachstehend erläuterten Optimierungsmodell gemeinsam mit einer initialen Zuordnung von Clustern auf die beiden Bestückungslinien, auf denen sie jeweils mit einer zuvor fertig erstellten Varianten- und/oder Festrüstung gefertigt werden, optimiert wird.

Letztendlich wird mit der erreichten optimierten Zuordnung und Reihenfolge der Cluster die Produktion der Leiterplatten 120 physisch durchgeführt, wobei die virtuellen Rüstungen quasi als "Platzhalter" im unten näher beschriebenen Optimierungsmodell darstellen. So gesehen rücken die realen Rüstungen bei der realen Vorrüstung und in der realen Produktion in der Reihenfolge auf.

Es kann zusätzlich die maximale Produktionszeitdauer pro Bestückungslinie festgelegt werden. Diese maximale Produktionszeitdauer kann in die obige Optimierung eingehen.

Aus der Menge der Cluster kann eine Untermenge an Cluster bestimmt werden, die auf einer bestimmbaren oder bestimmten Bestückungslinie der Bestückungslinien nicht gefertigt werden dürfen bzw. können. Dies beeinflusst letztendlich auch die Verwendung der Variantenrüstungen an der jeweiligen Bestückungslinie.

Des Weiteren ist es möglich, dass in die Fertigung der Cluster Festrüstungen zwischengeschoben werden. Beispielsweise könnte im Beispiel die Variantenrüstung V3 eine Festrüstung sein, die auf einen Wechseltischsatz fest gerüstet ist. Es entstehen für die Cluster mit Festrüstungen dann gegebenenfalls keine Wartezeiten, da die Festrüstungen nur einmal aufgerüstet werden und dann dafür einen längeren (Planungs-)Zeitraum beibehalten werden. Der gestrichelte Pfeil deutet dies an. Festrüstungen können in die Produktionsreihenfolge z.B. PL1 an "Zwischenpositionen" eingeschoben bzw. dazwischengeschoben werden. Dies bringt den Vorteil mit sich, dass auf diese Weise Wartezeiten in der Produktion auf die Fertigstellung der benötigten Variantenrüstungen vermieden werden können. Vorzugsweise werden Festrüstungen am Anfang bzw. am Ende der Produktionsreihenfolge eingesetzt.

Im folgenden MILP-Modell werden auf mindestens zwei Bestückungslinien eine Anzahl an Clustern mit realen Rüstungen sowie eine Anzahl an Clustern mit virtuellen Rüstungen (= Anzahl Linien * Anzahl reale Cluster - Anzahl reale Cluster) zugeordnet werden.

In der Formulierung des Optimierungsmodells in Form eines MILP-Modells gelten die folgenden Bezeichnungen:

Indizes:

$L$     Menge der Bestückungslinien

$V$     Menge der variablen Rüstfamilien bzw. Cluster (reale und Dummy-Rüstfamilien)

$P^l$     Menge der Reihenfolge-Positionen für die variablen Rüstfamilien, $P^l = \{1, ..., |V|\}$ auf Bestückungslinie $l \in L$

$T^l$     Menge der Wechseltischsätze auf Bestückungslinie $l \in L$

$P_s^l$     Aufsteigend sortierte Menge an Positionen, an denen Wechseltischsatz $s \in T^l$ verwendet wird

$PTime_r^l$     Produktionszeitdauer von Rüstfamilie r inklusiver der Umrüstzeitdauer an der Bestückungslinie l

$RTime_r^l$     Zeitdauer für die Erstellung der Rüstung für die Rüstfamilie r an der Bestückungslinie l

$EarliestBegin_L^l$     Frühestmöglicher Beginn der Produktion an der Bestückungslinie l

$EarliestBegin_R^l$     Frühestmöglicher Beginn des Rüstens im Vorrüstbereich von Bestückungslinie l

$EarliestBegin_s^l$     Frühestmöglicher Einsatz für Wechseltischsatz $s \in T^l$ auf Bestückungslinie l

Binärvariablen:

$assign_{v,p}^l$     Variable, die angibt, ob die Rüstfamilie v an p-ter Position der Produktionsreihenfolge der Bestückungslinie l produziert wird. (In diesem Fall nimmt sie den Wert 1 an, anderenfalls den Wert 0)

$beginP_p^l$     Beginn der Fertigung bzw. Produktion der Rüstfamilie an p-ter Position der Produktionsreihenfolge der Bestückungslinie l

$beginV_p^l$     Beginn der Rüstungserstellung für die Rüstfamilie an p-ter Position der Rüstreihenfolge für die Bestückungslinie l

$endP_p^l$     Ende der Produktion der Rüstfamilie an p-ter Position der Produktionsreihenfolge der Bestückungslinie l

$endV_p^l$     Ende der Rüstungserstellung für die Rüstfamilie an p-ter Position der Rüstreihenfolge für die Bestückungslinie l

IP-Formulierung:

Die Zielfunktion lautet:

Minimiere

$$\sum_{l \in L} end_{|P^l|}^l$$

Nebenbedingungen:

(1) Jede Rüstfamilie muss einer Position an einer Bestückungslinie zugeordnet sein.

$$\sum_{l \in L} \sum_{p \in P^l} assign_{v,p}^l = 1, \qquad v \in V$$

(2) Jeder Position muss eine Rüstfamilie zugewiesen sein.

$$\sum_{v \in V} \text{assign}^l_{v,p} = 1 \qquad l \in L, p \in P^l$$

(3) Die Produktion einer Rüstfamilie an Position p einer Bestückungslinie l kann erst beginnen, wenn die Rüstung im Vorrüstbereich erstellt ist.

$$endV^l_p \leq beginP^l_p \qquad l \in L, p \in P^l$$

(4) Die Erstellung der Rüstung für die Rüstfamilie an Position p einer Bestückungslinie kann erst beginnen, wenn die Erstellung der Rüstung der Rüstfamilie an der Position p-1 abgeschlossen ist.

$$endV^l_{p-1} \leq beginV^l_p \qquad p = 2, \ldots, |P^l|$$

(5) An Bestückungslinie l kann die Rüstungserstellung für die Rüstfamilie an p-ter Position erst beginnen, wenn der zugewiesene Wechseltischsatz frei bzw. leer ist.

$$endP^l_{p'} \leq beginV^l_p \qquad p \ direkter \ Nachfolger \ von \ p' \ in \ P^l_s, s \in T^l$$

(6) Berücksichtigung der Produktionszeitdauern

$$endP^l_p = beginP^l_p + \sum_{v \in V} \text{PTime}^l_r \ \text{assign}^l_{v,p} \qquad l \in L, p \in P^l$$

(7) Berücksichtigung der Rüstzeitdauern im Vorrüstbereich

$$endV^l_p = beginV^l_p + \sum_{v \in V} \text{RTime}^l_r \ \text{assign}^l_{v,p} \qquad l \in L, p \in P^l$$

(8) Die Produktion einer Rüstfamilie an Position p an einer Bestückungslinie l kann erst beginnen, wenn die Produktion der Rüstfamilie an der Position p-1 abgeschlossen ist

$$endP^l_{p-1} \leq beginP^l_p \qquad l \in L, p = 2, \ldots, |P^l|$$

(9) Die Produktion an der Bestückungslinie kann initial erst beginnen, wenn die Bestückungslinie dafür verfügbar ist.

$$EarliestBegin^l_L \leq beginP^l_1 \qquad l \in L$$

(10) Die Rüsterstellung im Vorrüstbereich kann initial erst beginnen, wenn die Bestückungslinie dafür verfügbar ist.

$$EarliestBegin^l_V \leq beginV^l_1 \qquad l \in L$$

(11) Der Wechseltischsatz $s \in T^l$ kann initial erst eingesetzt werden, wenn er verfügbar ist.

$$EarliestBegin_s^l \leq beginV_p^l \qquad l \in L, s$$
$$\in T^l, p \; erstes \; Element \; in \; P_s^l$$

(12) Variablenrestriktionen

$$assign_{v,p}^l \in \{0,1\} \qquad l \in L, v \in V, p \in P^l$$

$$beginP_p^l \geq 0 \qquad l \in L, p \in P^l$$

$$beginV_p^l \geq 0 \qquad l \in L, p \in P^l$$

$$endP_p^l \geq 0 \qquad l \in L, p \in P^l$$

$$endV_p^l \geq 0 \qquad l \in L, p \in P^l$$

Erweiterungen bzw. Ergänzungen:

a) Obere Produktionszeitdauerschranken an den Bestückungslinien

Ist die Produktionszeitdauer an einer Bestückungslinie beschränkt, weil z.B. die gesamte Fertigung maximal einen Tag dauern darf und ist MaxP$^l$ die obere Produktionszeitdauerschranke einer Bestückungslinie l, so lässt sich dies mit den folgenden Restriktionen mit in das Modell aufnehmen:

$$endP_{|P^l|}^l \leq MaxP^l \qquad l \in L$$

b) Linien-Restriktionen von Rüstfamilien

Darf eine Rüstfamilie v nicht auf gewissen Bestückungslinien **ForbiddenLines$_v \subset$ L** gefertigt werden, so lassen sich folgende Restriktionen mit in das Modell aufnehmen:

$$\sum_{p \in P^l} assign_{v,p}^l = 0 \qquad v \in V, l \in ForbiddenLines_v$$

c) Beschränkung von der Anzahl von Rüstfamilien (maxCluster) an einer oder mehreren Bestückungslinien

Soll die Anzahl der Rüstfamilien auf einer Bestückungslinie auf eine Anzahl maxCluster$^l$ beschränkt werden, so werden für diese Bestückungslinie nur maxCluster$^l$ Positionen zur Verfügung gestellt ( **$P^l$ = {1, ..., maxCluster$^l$}** ) . Die Anzahl der Dummy-Rüstfamilien vermindert sich dann entsprechend.
Mit solchen Beschränkungen lässt sich auch die Laufzeitleistung verbessern.

d) Berücksichtigung von Festrüstungen

Festrüstungen und die damit verbundenen Rüstfamilien lassen sich auch wie in der eingangs genannten Patentanmeldung PCT/EP2017/051997 in diesen MILP-Ansatz integrieren. Sie können als Puffer zwischen den Varianten-Rüstungen eingesetzt werden, um Stillstandzeiten wegen zu langer Zeitdauern für die Rüstungserstellung zu vermeiden.
Folgende damit verbundene Erweiterungen sind ebenfalls möglich:

- Berücksichtigung von "nicht vorhandenen" Umrüstzeiten

Ist die zuletzt vor dem Planungszeitraum produzierte Rüstung eine Festrüstung f' und muss diese Festrüstung im zu optimierenden Planungszeitraum ebenfalls gefertigt werden, so lässt sich die Umrüstzeit für diese Festrüstung einsparen, wenn sie als Erstes gefertigt wird.

- Bevorzugt Festrüstung am Schluss

Aus dem in (1) beschriebenen Grund ist es günstig, eine Festrüstung am Ende zu fertigen. Dazu kann eine Zielfunktions-Komponente mit einer kleinen Gewichtung mit in die Minimierungs-Zielfunktion aufgenommen werden.

- Mögliche Teilung einer Festrüstung

Treten in der optimalen Lösung des Modells Wartezeiten auf, so lassen sich diese eventuell vermeiden, wenn zugelassen wird, dass eine Festrüstungs-Rüstfamilien nicht in einem Stück gefertigt wird, sondern in mehrere Teile aufgeteilt werden kann, die dann jeweils als Puffer zwischen VariantenRüstungen eingesetzt werden können. Für jeden Teil der Festrüstungs-Rüstfamilie fällt dann eine entsprechende Umrüstzeit an.

Durch Minimierung der Durchlaufzeit(dauer) kann der Durchsatz insgesamt an mehreren Bestückungslinien verbessert bzw. optimiert werden. Letztendlich wird die Produktion der Leiterplatten mit Hilfe der oben optimierten Zuordnung auf die jeweiligen Bestückungslinien und optimierten Reihenfolge durchgeführt.

Das zu Figur 2 erläuterte Beispiel ist ein vereinfachtes Modell. In der Realität sind die Optimierungsprobleme komplexer. Um komplexe Optimierungsprobleme zu lösen, können solche MILP-Modelle der oben erläuterten Art eingesetzt werden. Obwohl die Erfindung im Detail durch das bevorzugte Ausführungsbeispiel näher illustriert und beschrieben wurde, so ist die Erfindung nicht durch die offenbarten Beispiele eingeschränkt und andere Variationen können vom Fachmann hieraus abgeleitet werden, ohne den Schutzumfang der Erfindung zu verlassen, wie er durch die angehängten Ansprüche definiert ist.

Die Implementierung der vorstehend beschriebenen Prozesse oder Verfahrensabläufe kann anhand von Instruktionen erfolgen, die auf computerlesbaren Speichermedien oder in flüchtigen Computerspeichern (im Folgenden zusammenfassend als computerlesbare Speicher bezeichnet) vorliegen. Computerlesbare Speicher sind beispielsweise flüchtige Speicher wie Caches, Puffer oder RAM sowie nichtflüchtige Speicher wie Wechseldatenträger, Festplatten, usw.

Die vorstehend beschriebenen Funktionen oder Schritte können dabei in Form zumindest eines Instruktionssatzes in/auf einem computerlesbaren Speicher vorliegen. Die Funktionen oder Schritte sind dabei nicht an einen bestimmten Instruktionssatz oder an eine bestimmte Form von Instruktionssätzen oder an ein bestimmtes Speichermedium oder an einen bestimmten Prozessor oder an bestimmte Ausführungsschemata gebunden und können durch Software, Firmware, Microcode, Hardware, Prozessoren, integrierte Schaltungen usw. im Alleinbetrieb oder in beliebiger Kombination ausgeführt werden. Dabei können verschiedenste Verarbeitungsstrategien zum Einsatz kommen, beispielsweise serielle Verarbeitung durch einen einzelnen Prozessor oder Multiprocessing oder Multitasking oder Parallelverarbeitung usw.

Die Instruktionen können in lokalen Speichern abgelegt sein, es ist aber auch möglich, die Instruktionen auf einem entfernten System abzulegen und darauf via Netzwerk zuzugreifen.

Der Begriff "Prozessor", "zentrale Signalverarbeitung", "Steuereinheit" oder "Datenauswertemittel", wie hier verwendet, umfasst Verarbeitungsmittel im weitesten Sinne, also beispielsweise Server, Universalprozessoren, Grafikprozessoren, digitale Signalprozessoren, anwendungsspezifische integrierte Schaltungen (ASICs), programmierbare Logikschaltungen wie FPGAs, diskrete analoge oder digitale Schaltungen und beliebige Kombinationen davon, einschließlich aller anderen dem Fachmann bekannten oder in Zukunft entwickelten Verarbeitungsmittel. Prozessoren können dabei aus einer oder mehreren Vorrichtungen bzw. Einrichtungen bzw. Einheiten bestehen. Besteht ein Prozessor aus mehreren Vorrichtungen, können diese zur parallelen oder sequentiellen Verarbeitung bzw. Ausführung von Instruktionen ausgelegt bzw. konfiguriert sein.

## Patentansprüche

1. Verfahren zur durchsatzoptimierten Produktion von Leiterplatten (120) auf mindestens zwei Bestückungslinien (110), wobei die Leiterplatten in Gruppen aufgeteilt sind, die Cluster genannt werden, wobei ein Cluster (175) jeweils mittels einer Rüstung gefertigt wird, wobei die Rüstung durch an den Bestückungslinien anbringbaren Wechseltische (140) realisiert wird, die jeweils mindestens eine Zuführungseinrichtung (150) zum Bereithalten von Vorräten von Bauelementen (155) aufweisen, wobei eine Menge von pro Rüstung notwendigen Wechseltischen als Wechseltischsatz bezeichnet wird und ein leerer Wechseltischsatz Wechseltische aufweist, deren Zuführungseinrichtungen leer sind,

- wobei eine Rüstung temporär auf leeren Wechseltischsätzen aufgerüstet und nach der Produktion von Leiterplatten durch deren Bestückung abgerüstet wird, und

- wobei einer der Wechseltischsätze erst dann in der Produktion einsetzbar ist, wenn er vollständig in einem Vorrüstbereich aufgerüstet worden ist, und der Wechseltischsatz erst dann wieder aufrüstbar ist, wenn die mit dem Wechseltischsatz durchgeführte Produktion beendet und der Wechseltischsatz im Vorrüstbereich wieder abgerüstet worden ist,

wobei das Verfahren folgende Schritte umfasst:

a) Erfassen einer Menge von Bestückungslinien,
b) Erfassen einer Menge von Clustern,
c) Erfassen einer Anzahl an leeren Wechseltischsätzen pro Bestückungslinie,
d) Erfassen der jeweiligen Zeitdauern für das Erstellen der Rüstung für die einzelnen Cluster der erfassten Menge von Clustern pro Bestückungslinie,
e) Erfassen der jeweiligen Produktionszeitdauern für die Fertigung der einzelnen Cluster der erfassten Menge von Clustern auf einer der Bestückungslinien,
f) Auswählen einer Zuordnung von Wechseltischsätzen zu Positionen in einer zeitlichen Reihenfolge, in welcher die Wechseltischsätze im Vorrüstbereich gerüstet werden und in der gleichen zeitlichen Reihenfolge in der Produktion verwendet werden, wobei die Anzahl der Positionen in der zeitlichen Reihenfolge der Anzahl der erfassten Cluster entspricht und jeder Position ein Cluster zugeordnet wird,
g) Optimierung einer Zuordnung der Cluster auf die Bestückungslinien und der Reihenfolge der zugeordneten Cluster pro Bestückungslinie, so dass die Durchlaufzeit insgesamt bezogen auf alle Bestückungslinien minimiert wird, und
h) Durchführung der Produktion der Leiterplatten mit Hilfe der in g) berechneten, optimierten Zuordnung und Reihenfolge der Cluster.

2. Verfahren nach dem vorhergehenden Anspruch, **dadurch gekennzeichnet, dass** jeweils eine maximale Produktionszeitdauer pro Bestückungslinie festlegbar ist.

3. Verfahren nach einem der vorhergehenden Ansprüche, **dadurch gekennzeichnet, dass** eine maximale Anzahl an Clustern jeweils auf einer Bestückungslinie festlegbar ist, welche auf der jeweiligen Bestückungslinie gefertigt werden können.

4. Verfahren nach einem der vorhergehenden Ansprüche, **dadurch gekennzeichnet, dass** aus der Menge der Cluster eine Untermenge an Clustern vorgebbar ist, die auf einer bestimmbaren Bestückungslinie der Bestückungslinien nicht gefertigt werden dürfen.

5. Verfahren nach einem der vorhergehenden Ansprüche, **dadurch gekennzeichnet, dass** des Weiteren folgende Schritte durchgeführt werden:

- Erfassen eines oder mehrerer frühestmöglichen Zeitpunkte für den Beginn des Einsatzes eines Wechseltischsatzes pro Bestückungslinie,
- Erfassen eines frühestmöglichen Zeitpunkts pro Bestückungslinie für den Beginn der Produktion,
- Erfassen eines frühestmöglichen Zeitpunkts pro Bestückungslinie für den Beginn des Rüstens im Vorrüstbereich, und
- Optimierung der Zuordnung und Reihenfolge der Cluster unter Berücksichtigung der erfassten frühesten Zeitpunkte.

6. Verfahren nach einem der vorhergehenden Ansprüche,
**dadurch gekennzeichnet, dass** die Optimierung der Zuordnung und der Reihenfolge der Cluster mit Hilfe von Gemischt Ganzzahliger Linearer Optimierung durchgeführt wird.

7. Verfahren nach dem vorhergehenden Anspruch, **dadurch gekennzeichnet, dass** in die gemischt ganzzahlige lineare Optimierung Cluster unterteilt in reale Cluster und virtuelle Cluster eingehen, wobei nach Optimierung der Zuordnung und der Reihenfolge der Cluster die virtuellen Cluster herausgenommen werden und die übrigen Cluster in der jeweiligen Reihenfolge aufrücken.

8. Verfahren nach einem der vorhergehenden Ansprüche, **dadurch gekennzeichnet, dass** unterschiedliche Typen von Rüstungen verwendet werden, wobei ein erster Typ einer Festrüstung entspricht, die nach einem einmaligen Rüsten unverändert bleibt und vor der Produktion nicht ab- und aufgerüstet wird sowie pro Festrüstung ein Wechseltischsatz vorgesehen ist, wobei ein zweiter Typ einer Variantenrüstung (V1, ..., V10) entspricht, die gemäß der vorhergehenden Ansprüche veränderbar ist und für die Variantenrüstungen mindestens ein Wechseltischsatz vorgesehen ist und wobei jedes Cluster mit einer Rüstung eines vorgebbaren Typs der genannten Typen gefertigt wird.

9. Verfahren nach einem vorhergehenden Anspruch, **dadurch gekennzeichnet, dass** zusätzlich Umrüstzeiten erfasst und für die Optimierung berücksichtigt werden, die durch das Wechseln der Wechseltischsätze beim Übergang von einer Rüstung auf eine andere Rüstung auftreten.

10. Verfahren nach dem vorhergehenden Anspruch, **dadurch gekennzeichnet, dass** ein Cluster mit einer Festrüstung aufgeteilt werden kann und mehrfach in die Reihenfolge der Cluster eingebracht werden kann.

11. Steuerungseinrichtung, insbesondere zur Durchführung des Verfahren zur durchsatzoptimierten Produktion von Leiterplatten (120) auf mindestens zwei Bestückungslinien (110) nach einem der vorhergehenden Ansprüche, wobei die Leiterplatten in Gruppen aufteilbar sind, die Cluster (175) genannt werden, wobei ein Cluster jeweils mittels einer Rüstung gefertigt wird, wobei die Rüstung durch an den Bestückungslinien anbringbaren Wechseltische (140) realisierbar ist, die jeweils mindestens eine Zuführungseinrichtung (150) zum Bereithalten von Vorräten von Bauelementen (155) aufweisen, wobei eine Menge von pro Rüstung notwendigen Wechseltischen als Wechseltischsatz bezeichnet wird und ein leerer Wechseltischsatz Wechseltische aufweist, deren Zuführungseinrichtungen leer sind,

   - wobei eine Rüstung temporär auf leeren Wechseltischsätzen aufrüstbar und nach der Produktion von Leiterplatten durch deren Bestückung abrüstbar ist, und

   - wobei einer der Wechseltischsätze erst dann in der Produktion einsetzbar ist, wenn er vollständig in einem Vorrüstbereich aufgerüstet worden ist, und der Wechseltischsatz erst dann wieder aufrüstbar ist, wenn die mit dem Wechseltischsatz durchgeführte Produktion beendet und der Wechseltischsatz im Vorrüstbereich wieder abgerüstet worden ist,

   wobei die Steuereinheit folgende Erfassungseinrichtungen

   a) zum Erfassen einer Menge von Bestückungslinien,
   b) zum Erfassen einer Menge von Clustern,
   c) zum Erfassen einer Anzahl an leeren Wechseltischsätzen,
   d) zum Erfassen der jeweiligen Zeitdauern für das Erstellen der Rüstung für die einzelnen Cluster der erfassten Menge von Clustern pro Bestückungslinie,
   e) zum Erfassen der jeweiligen Produktionszeitdauern für die Fertigung der einzelnen Cluster der erfassten Menge von Clustern auf einer der Bestückungslinien,
   f) zum Auswählen einer Zuordnung von Wechseltischsätzen zu Positionen in einer zeitlichen Reihenfolge, in welcher die Wechseltischsätze im Vorrüstbereich gerüstet werden und in der gleichen zeitlichen Reihenfolge in der Produktion verwendet werden, wobei die Anzahl der Positionen in der zeitlichen Reihenfolge der Anzahl der erfassten Cluster entspricht und jeder Position ein Cluster zugeordnet wird, und
   g) Solver zur Optimierung einer Zuordnung der Cluster auf die Bestückungslinien und der Reihenfolge der zugeordneten Cluster pro Bestückungslinie, so dass die Durchlaufzeit insgesamt bezogen auf alle Bestückungslinien minimiert ist, sowie
   h) eine Steuerung zur Durchführung der Produktion der Leiterplatten mit Hilfe der in g) berechneten, optimierten Zuordnung und Reihenfolge der Cluster, aufweist.

12. Steuerungseinrichtung nach dem vorhergehenden Anspruch, **dadurch gekennzeichnet, dass** die Optimierung der Zuordnung und der Reihenfolge der Cluster mit Hilfe von Gemischt Ganzzahliger Linearer Optimierung durchführbar ist.

13. Steuerungseinrichtung nach dem vorhergehenden Anspruch, **dadurch gekennzeichnet, dass** in die gemischt ganzzahlige lineare Optimierung Cluster unterteilt in reale Cluster und virtuelle Cluster eingehen, wobei die gemischt ganzzahlige Optimierung dazu ausgelegt ist, nach Optimierung der Zuordnung und der Reihenfolge der Cluster die virtuellen Cluster herauszunehmen und die übrigen Cluster in der jeweiligen Reihenfolge aufzurücken.

14. Steuerungseinrichtung nach einem der vorhergehenden Ansprüche 11 bis 13, **dadurch gekennzeichnet, dass** unterschiedliche Typen von Rüstungen verwendbar sind, wobei ein erster Typ einer Festrüstung entspricht, die nach einem einmaligen Rüsten unverändert bleibt und vor der Produktion nicht ab- und aufgerüstet wird sowie pro Festrüstung ein Wechseltischsatz vorgesehen ist, wobei ein zweiter Typ einer Variantenrüstung (V1, ..., V10) entspricht, die gemäß der vorhergehenden Ansprüche 11 bis 13 veränderbar ist und für die Variantenrüstungen mindestens ein Wechseltischsatz vorgesehen ist und wobei jedes Cluster mit einer Rüstung eines vorgebbaren Typs der genannten Typen gefertigt werden kann.

15. Computerprogrammprodukt mit Programmcodemitteln zur Durchführung des Verfahrens nach einem der vorangehenden Ansprüche, wenn es auf einer Steuerungseinrichtung nach einem der vorangehenden Ansprüche abläuft.

**Claims**

1. Method for the throughput-optimized production of printed circuit boards (120) on at least two pick-and-place lines (110), wherein the printed circuit boards are divided into groups called clusters, wherein a cluster (175) is produced in each case by means of a fitting, wherein the fitting is realized by shuttle tables (140) which are attachable to the pick-and-place lines and which each have at least one feed device (150) for keeping ready supplies of components (155), wherein a quantity of shuttle tables required per fitting is referred to as a shuttle table set and an empty shuttle table set has shuttle tables with feed devices that are empty,

   - wherein a fitting is mounted temporarily on empty shuttle table sets and is demounted after the production of printed circuit boards as a result of the population thereof, and

      - wherein one of the shuttle table sets is usable in production only if it has been completely equipped in a prefitting region, and the shuttle table set is equippable again only if production carried out with the shuttle table set has ended and the shuttle table set has been stripped again in the prefitting region,

   wherein the method comprises the following steps:

      a) detecting a set of pick-and-place lines,
      b) detecting a set of clusters,
      c) detecting a number of empty shuttle table sets per pick-and-place line,
      d) detecting the respective time durations for creating the fitting for the individual clusters of the detected set of clusters per pick-and-place line,
      e) detecting the respective production time durations for producing the individual clusters of the detected set of clusters on one of the pick-and-place lines,
      f) selecting an assignment of shuttle table sets to positions in a temporal order in which the shuttle table sets are equipped in the prefitting region and are used in the same temporal order in production, wherein the number of positions in the temporal order corresponds to the number of detected clusters and each position is assigned a cluster,
      g) optimizing an assignment of the clusters to the pick-and-place lines and the order of the assigned clusters per pick-and-place line, such that the turnaround time is minimized overall relative to all the pick-and-place lines,
      h) carrying out the production of the printed circuit boards with the aid of the optimized assignment and order of the clusters calculated in g).

2. Method according to the preceding claim, **characterized in that** in each case a maximum production time duration per pick-and-place line is definable.

3. Method according to either of the preceding claims, **characterized in that** a maximum number of clusters in each case on a pick-and-place line is definable, which clusters can be produced on the respective pick-and-place line.

4. Method according to one of the preceding claims, **characterized in that** a subset of clusters which are not permitted to be produced on a determinable pick-and-place line of the pick-and-place lines is predefinable from the set of clusters.

5. Method according to one of the preceding claims, **characterized in that** the following steps are furthermore carried out:

- detecting one or a plurality of earliest possible points in time for the beginning of the use of a shuttle table set per pick-and-place line,
- detecting an earliest possible point in time per pick-and-place line for the beginning of production,
- detecting an earliest possible point in time per pick-and-place line for the beginning of fitting in the prefitting region, and
- optimizing the assignment and order of the clusters taking account of the earliest points in time detected.

6. Method according to one of the preceding claims, **characterized in that** optimizing the assignment and the order of the clusters is carried out with the aid of mixed integer linear optimization.

7. Method according to the preceding claim, **characterized in that** clusters subdivided into real clusters and virtual clusters influence the mixed integer linear optimization, wherein after optimizing the assignment and the order of the clusters, the virtual clusters are extracted and the remaining clusters move up in the respective order.

8. Method according to one of the preceding claims, **characterized in that** different types of fittings are used, wherein a first type corresponds to a fixed fitting, which, after one-off fitting, remains unchanged and is not demounted and mounted before production, and one shuttle table set is provided per fixed fitting, wherein a second type corresponds to a variant fitting (V1, ..., V10), which is variable in accordance with the preceding claims, and at least one shuttle table set is provided for the variant fittings and wherein each cluster is produced with a fitting of a predefinable type of the types mentioned.

9. Method according to a preceding claim, **characterized in that** fitting conversion times are additionally detected and taken into account for the optimization, said times occurring as a result of changing the shuttle table sets upon the transition from one fitting to another fitting.

10. Method according to the preceding claim, **characterized in that** a cluster with a fixed fitting can be divided and can be introduced multiply into the order of the clusters.

11. Control device, in particular for carrying out the method for the throughput-optimized production of printed circuit boards (120) on at least two pick-and-place lines (110) according to one of the preceding claims, wherein the printed circuit boards are divisible into groups called clusters (175), wherein a cluster is produced in each case by means of a fitting, wherein the fitting is realizable by shuttle tables (140) which are attachable to the pick-and-place lines and which each have at least one feed device (150) for keeping ready supplies of components (155), wherein a quantity of shuttle tables required per fitting is referred to as a shuttle table set and an empty shuttle table set has shuttle tables with feed devices that are empty,

- wherein a fitting is mountable temporarily on empty shuttle table sets and is demountable after the production of printed circuit boards as a result of the population thereof, and

- wherein one of the shuttle table sets is usable in production only if it has been completely equipped in a prefitting region, and the shuttle table set is equippable again only if production carried out with the shuttle table set has ended and the shuttle table set has been stripped again in the prefitting region,

wherein the control unit comprises the following detection devices:

a) for detecting a set of pick-and-place lines,
b) for detecting a set of clusters,
c) for detecting a number of empty shuttle table sets,
d) for detecting the respective time durations for creating the fitting for the individual clusters of the detected set of clusters per pick-and-place line,
e) for detecting the respective production time durations for producing the individual clusters of the detected set of clusters on one of the pick-and-place lines,
f) for selecting an assignment of shuttle table sets to positions in a temporal order in which the shuttle table sets are equipped in the prefitting region and are used in the same temporal order in production, wherein the number of positions in the temporal order corresponds to the number of detected clusters and each position is assigned a cluster, and

g) solvers for optimizing an assignment of the clusters to the pick-and-place lines and the order of the assigned clusters per pick-and-place line, such that the turnaround time is minimized overall relative to all the pick-and-place lines, and also

h) a control for carrying out the production of the printed circuit boards with the aid of the optimized assignment and order of the clusters calculated in g).

12. Control device according to the preceding claim, **characterized in that** optimizing the assignment and the order of the clusters is able to be carried out with the aid of mixed integer linear optimization.

13. Control device according to the preceding claim, **characterized in that** clusters subdivided into real clusters and virtual clusters influence the mixed integer linear optimization, wherein the mixed integer optimization is designed so as, after optimizing the assignment and the order of the clusters, to extract the virtual clusters and to move up the remaining clusters in the respective order.

14. Control device according to one of the preceding Claims 11 to 13, **characterized in that** different types of fittings are usable, wherein a first type corresponds to a fixed fitting, which, after one-off fitting, remains unchanged and is not demounted and mounted before production, and one shuttle table set is provided per fixed fitting, wherein a second type corresponds to a variant fitting (V1, ..., V10), which is variable in accordance with the preceding Claims 11 to 13, and at least one shuttle table set is provided for the variant fittings and wherein each cluster can be produced with a fitting of a predefinable type of the types mentioned.

15. Computer program product comprising program code means for carrying out the method according to one of the preceding claims when it is executed on a control device according to one of the preceding claims.

**Revendications**

1. Procédé de production au débit optimisé de platines de circuits imprimés (120) sur au moins deux lignes de montage (110), les platines étant réparties en groupes appelés clusters, un cluster (175) étant préparé respectivement au moyen d'un équipement, l'équipement étant réalisé par des tables de transfert (140) pouvant être fixées sur les lignes de montage, les tables de transfert présentant respectivement au moins un dispositif d'approvisionnement (150) pour la mise à disposition de stocks d'éléments de construction (155), où un ensemble de tables de transfert désigne une quantité de tables de transfert nécessaires par équipement et où un ensemble de tables de transfert vide comporte des tables de transfert dont les dispositifs d'approvisionnement sont vides,

- dans lequel un équipement est temporairement monté sur des ensembles de tables de transfert vides et démonté après la production de platines du fait de leur montage, et
- dans lequel un des ensembles de tables de transfert peut s'utiliser uniquement s'il a été entièrement monté dans une zone de préparation, et l'ensemble de tables de transfert ne peut être remonté que si la production réalisée avec l'ensemble de tables de transfert prend fin et si l'ensemble de tables de transfert a été démonté à nouveau dans la zone de préparation,

le procédé comprenant les étapes suivantes :

a) établissement d'un certain nombre de lignes de montage,
b) établissement d'un certain nombre de clusters,
c) établissement d'un nombre d'ensembles de tables de transfert vides par ligne de montage,
d) établissement des durées respectives de création de l'équipement pour chaque cluster de la quantité établie de clusters par ligne de montage,
e) établissement des durées respectives de production pour la mise à disposition de chaque cluster de la quantité établie de clusters sur une ligne de montage,
f) sélection d'une affectation d'ensembles de tables de transfert à des positions dans un ordre chronologique dans lequel les ensembles de tables de transfert sont préparés dans la zone de préparation et sont utilisés dans le même ordre chronologique dans la production, le nombre de positions dans l'ordre chronologique correspondant au nombre de clusters établis et un cluster étant affecté à chaque position.
g) optimisation d'une affectation des clusters sur les lignes de montage et de la succession des clusters affectés par ligne de montage, pour minimiser la durée totale rapportée à toutes les lignes de montage, et

h) réalisation de la production des platines à l'aide de l'affectation calculée en g) et optimisée et de la succession des clusters.

**2.** Procédé selon la revendication précédente, **caractérisé en ce qu'**on peut déterminer respectivement une durée maximale de production par ligne de montage.

**3.** Procédé selon l'une des revendications précédentes, **caractérisé en ce qu'**on peut déterminer respectivement sur une ligne de montage un nombre maximum de clusters qui peuvent être préparés sur leur ligne de montage respective.

**4.** Procédé selon l'une des revendications précédentes, **caractérisé en ce qu'**on peut imposer un sous-ensemble de clusters de la quantité de clusters qu'on ne peut pas préparer sur une ligne de montage identifiable parmi les lignes de montage.

**5.** Procédé selon l'une des revendications précédentes, **caractérisé en ce qu'**en outre les étapes suivantes sont effectuées :

- établissement d'au moins un moment aussi précoce que possible pour le début de l'utilisation d'un ensemble de tables de transfert par ligne de montage,
- établissement d'un moment aussi précoce que possible par ligne de montage pour le début de la production,
- établissement d'un moment aussi précoce que possible par ligne de montage pour le début de la préparation dans la zone de préparation, et
- optimisation de l'affectation et de la succession des clusters en prenant en compte les moments les plus précoces possibles établis.

**6.** Procédé selon l'une des revendications précédentes, **caractérisé en ce que** l'optimisation de l'affectation et de la succession chronologique des clusters sont réalisées à l'aide d'une optimisation linéaire en nombres entiers.

**7.** Procédé selon l'une des revendications précédentes, **caractérisé en ce que** dans l'optimisation linéaire en nombres entiers, les clusters sont répartis en clusters réels et en clusters virtuels, les clusters virtuels étant retirés et les clusters restants étant promus dans la succession correspondante après optimisation de l'affectation et de la succession des clusters.

**8.** Procédé selon l'une des revendications précédentes, **caractérisé en ce que** différents types d'équipements sont utilisés, un premier type correspondant à un équipement fixe qui reste inchangé après montage et n'est pas démonté et remonté avant production, et où un ensemble de tables de transfert est prévu par équipement fixe, un second type correspondant à une variante d'équipement (V1, ..., V10) qui peut être modifiée selon les revendications précédentes et où, pour les variantes d'équipement, au moins un ensemble de tables de transfert est prévu, et où chaque cluster est préparé avec un équipement d'un type pouvant être imposé parmi ces types.

**9.** Procédé selon l'une des revendications précédentes, **caractérisé en ce qu'**en plus sont établies et prises en compte pour l'optimisation des durées de changement d'équipement qui résultent du changement des ensembles de tables de transfert au moment du passage d'un équipement à un autre équipement.

**10.** Procédé selon l'une des revendications précédentes, **caractérisé en ce qu'**un cluster peut être réparti avec un équipement fixe et peut être introduit plusieurs fois dans la succession des clusters.

**11.** Dispositif de commande, en particulier pour la réalisation du procédé de production au débit optimisé de platines de circuits imprimés (120) sur au moins deux lignes de montage (110) selon l'une des revendications précédentes, les platines étant réparties en groupes appelés clusters (175), un cluster étant préparé respectivement au moyen d'un équipement, l'équipement pouvant être réalisé par des tables de transfert (140) pouvant être fixées sur les lignes de montage, les tables de transfert présentant respectivement au moins un dispositif d'approvisionnement (150) pour la mise à disposition de stocks d'éléments de construction (155), où un ensemble de tables de transfert désigne une quantité de tables de transfert nécessaires par équipement et où un ensemble de tables de transfert vide comporte des tables de transfert dont les dispositifs d'approvisionnement sont vides,

- dans lequel un équipement peut être temporairement monté sur des ensembles de tables de transfert vides et démonté après la production de platines du fait de leur montage, et

- dans lequel un des ensembles de tables de transfert peut s'utiliser uniquement s'il a été entièrement monté dans une zone de préparation, et l'ensemble de tables de transfert ne peut être remonté que si la production réalisée avec l'ensemble de tables de transfert prend fin et si l'ensemble de tables de transfert a été démonté à nouveau dans la zone de préparation,

l'unité de commande présentant les dispositifs d'établissement suivants :

a) pour établir un certain nombre de lignes de montage,
b) pour établir un certain nombre de clusters,
c) pour établir un nombre d'ensembles de tables de transfert vides,
d) pour établir des durées respectives de création de l'équipement pour chaque cluster de la quantité établie de clusters par ligne de montage,
e) pour établir des durées respectives de production pour la mise à disposition de chaque cluster de la quantité établie de clusters sur une ligne de montage,
f) pour sélectionner une affectation d'ensembles de tables de transfert à des positions dans un ordre chronologique dans lequel les ensembles de tables de transfert sont préparés dans la zone de préparation et sont utilisés dans le même ordre chronologique dans la production, le nombre de positions dans l'ordre chronologique correspondant au nombre de clusters établis et un cluster étant affecté à chaque position, et
g) un solveur pour optimiser une affectation des clusters sur les lignes de montage et de la succession des clusters affectés par ligne de montage, pour minimiser la durée totale rapportée à toutes les lignes de montage, ainsi
h) qu'une commande pour réaliser la production des platines à l'aide de l'affectation calculée en g) et optimisée et de la succession des clusters.

12. Dispositif de commande selon la revendication précédente, **caractérisé en ce que** l'optimisation de l'affectation et de la succession chronologique des clusters peuvent être réalisées à l'aide d'une optimisation linéaire en nombres entiers.

13. Dispositif de commande selon la revendication précédente, **caractérisé en ce que** dans l'optimisation linéaire en nombres entiers, les clusters sont répartis en clusters réels et en clusters virtuels, dans lequel l'optimisation en nombre entiers est configuré pour retirer les clusters virtuels et promouvoir les clusters restants dans la succession correspondante après optimisation de l'affectation et de la succession des clusters.

14. Procédé selon l'une des revendications précédentes 11 à 13, **caractérisé en ce que** différents types d'équipements peuvent être utilisés, un premier type correspondant à un équipement fixe qui reste inchangé après montage et n'est pas démonté et remonté avant production, et où un ensemble de tables de transfert est prévu par équipement fixe, un second type correspondant à une variante d'équipement (V1, ..., V10) qui peut être modifiée selon les revendications précédentes 11 à 13 et où, pour les variantes d'équipement, au moins un ensemble de tables de transfert est prévu, et où chaque cluster est préparé avec un équipement d'un type pouvant être imposé parmi ces types.

15. Produit programme informatique avec des moyens de codage de programme pour réaliser le procédé selon l'une des revendications précédentes s'il est appliqué sur un dispositif de commande selon l'une des revendications précédentes.

FIG 1

FIG 2

**EP 3 581 006 B1**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 102012211810 A1
- DE 102014222940 A1
- DE 102014222936 A1
- EP 2017051997 W